# EUROPEAN PATENT SPECIFICATION

(11) **EP 4 422 007 B1**
(45) Date of publication and mention of the grant of the patent: **01.04.2026**
(21) Application number: 23172868.4
(22) Date of filing: 11.05.2023
(51) Int. Cl.: H01S 5/02, H01S 5/10, H01S 5/20, G02B 6/12, H01S 5/026, H01S 5/12, H01S 5/14, H01S 5/22, H01S 5/227

(54) **HIGH POWER HETEROGENEOUS LASERS**
HETEROGENE HOCHLEISTUNGSLASER
LASERS HETEROGENES DE GRANDE PUISSANCE

(30) Priority: 25.02.2023 US 202318114244
(43) Date of publication of application: 28.08.2024
(73) Proprietor: Nexus Photonics, Inc., Goleta, CA 93117 (US)
(72) Inventor: KOMLJENOVIC, Tin, Goleta, 93117 (US); ZHANG, Zeyu, Goleta, 93117 (US); ZHANG, Chong, Santa Barbara, 93111 (US); TRAN, Minh, Goleta, 93117 (US)
(74) Representative: Isarpatent

(56) References cited:
- WO-A1-2015/038164
- US-B1- 11 287 573
- US-B1- 6 333 945
- US-B2- 10 916 918
- US-B2- 11 209 592

## Description

### Field of the Invention

The present invention relates to photonic integrated circuits. More specifically, certain embodiments of the invention relate to improved performance of heterogeneously integrated lasers and active components.

### Background of the Invention

A photonic integrated circuit (PIC) or integrated optical circuit is a device that integrates multiple photonic functions and as such is analogous to an electronic integrated circuit. The major difference between the two is that a photonic integrated circuit provides functions for information signals imposed on optical carrier waves. A photonic integrated circuit can also generate light with advanced properties in one chip. The material platform most commercially utilized for photonic integrated circuits is indium phosphide (InP), which allows for the integration of various optically active and passive functions on the same chip. Although many current PICs are realized in InP platforms, there has been significant research in the past decade in using silicon rather than InP for the realization of PICs, due to some superior characteristics as well as superior processing capabilities for the former material, that leverage the investment already made for electronic integrated circuits.

The biggest drawback in using silicon for PICs is that it is an indirect bandgap material which makes it hard to provide electrically pumped sources. This problem is generally solved by assembling PICs comprising two or more chips made from dissimilar materials in separate processes. Such an approach is challenging due to a need for very fine alignment, which increases packaging costs and introduces scaling limitations. Another approach to solving the bandgap problem is to bond two dissimilar materials and process them together, removing the need for precise alignment during the bonding of larger pieces or complete wafers of the dissimilar materials, and allowing for mass fabrication. In this disclosure, we use the term "hybrid" to describe the first approach that includes precise assembly of separately processed parts, and we use the term "heterogeneous" to describe the latter approach of bonding two materials and then processing the bonded result to define the waveguides and other components of interest.

To transfer the optical signal between dissimilar materials, the heterogeneous approach historically utilized tapers whose dimensions are gradually reduced until the effective mode refractive indexes of two or more materials match and there is efficient power transfer. This approach generally works well when materials have small difference in refractive indexes as is the case with silicon and InP. In cases where there is larger difference in effective indexes, such as between e.g. SiN and GaAs or InP, the requirements on taper tip dimensions become prohibitive limiting efficient power transfer.

Recently, a new class of heterogeneous PICs has been developed as described in e.g. US Patent No. US 11,209,592 B2 and US patent application 17,732,348 in which integration of optically dissimilar materials is facilitated without using prohibitively narrow tapers. Such PICs have demonstrated very good performance, especially in terms of laser noise (both frequency and amplitude) - primarily leveraging the low losses in the passive/waveguide material. At the same time, output powers of such lasers are generally limited to below 30 milliwatts (mW), very rarely as high as 100 mW, due to the resulting high intensity of the optical mode in the quantum well region, and with smaller mode sizes generally further increasing the optical mode intensity. Such high intensities can result in catastrophic optical damage (COD) if such lasers are operated at the high end of the output power.

Many applications require higher powered lasers, exceeding 100 mW, and approaching or even exceeding 1 watt (W). Such high powers can readily be supported by the passive waveguide realized in high-bandgap materials such as SiN, SiNOx, LiNbO₃, TiO₂, Ta₂O₅, AIN or others, but laser/active structure has to be further optimized to provide such high powers without COD and other impairments.

US 10,916,918 B1 describes an integrated photonic structure comprising a semiconductor stack on a substrate, partially isolated by openings to form a suspended semiconductor membrane. The structure includes distinct doped regions separated by an optically active region, which defines a waveguiding region. A fabrication method involves the formation of doped regions, quantum wells, and various semiconductor layers. Such an integrated photonic structure can be applied in high-speed optical modulators, low-noise semiconductor lasers, and other photonic devices with enhanced thermal dissipation and performance.

The present invention is defined by the appended claims and is directed towards heterogeneous lasers and PICs using high-bandgap dielectric¹ waveguides and supporting high power operations. In particular, embodiments described below are concerned with the detailed design of the active region and the optical coupling structure and waveguide design necessary for creation of high-performance, high-power heterogeneous lasers and PICs with dielectric waveguides.
¹ The term "dielectric" is used herein with its standard meaning of a material having very low electrical conductivity.

### Brief Description of the Drawings

FIG. 1 (PRIOR ART) illustrates a device according to one embodiment of the prior art, shown in cross-sectional end-on view.
FIG. 2 shows a cross-sectional end-on view of a device according to some embodiments of the present invention, with a graph of a corresponding optical mode profile.
FIG. 3 shows a cross-sectional end-on view of a device according to some embodiments of the present invention, with a graph of a corresponding optical mode profile.
FIG. 4 shows a cross-sectional end-on views of a device according to some embodiments of the present invention, with a graph of a corresponding optical mode profile.
FIG. 5 shows a detailed cross-sectional end-on view of a device according to some embodiments of the present invention, with a graph of a corresponding optical mode profile.
FIG. 6 illustrates a device according to one embodiment of the present invention, shown in cross section.
FIG. 7 shows a cross-sectional top-down view of a device according to some embodiments of the present invention.

### Detailed Description

Described herein include embodiments of a platform for realization of photonic integrated circuits using wafer bonding and deposition of dissimilar materials where optical coupling is improved by use of mode conversion and a butt-coupling scheme. More specifically, certain embodiments of the invention relate to improved high-power performance of heterogeneously integrated lasers and PICs with dielectric waveguides.

In the following detailed description, reference is made to the accompanying drawings which form a part hereof, wherein like numerals designate like parts throughout, and in which are shown by way of illustration embodiments in which the subject matter of the present disclosure may be practiced. It is to be understood that other embodiments may be utilized, and structural or logical changes may be made without departing from the scope of the present disclosure. Therefore, the following detailed description is not to be taken in a limiting sense, and the scope of embodiments is defined by the appended claims and their equivalents.

The description may use perspective-based descriptions such as top/bottom, in/out, over/under, and the like. Such descriptions are merely used to facilitate the discussion and are not intended to restrict the application of embodiments described herein to any particular orientation. The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

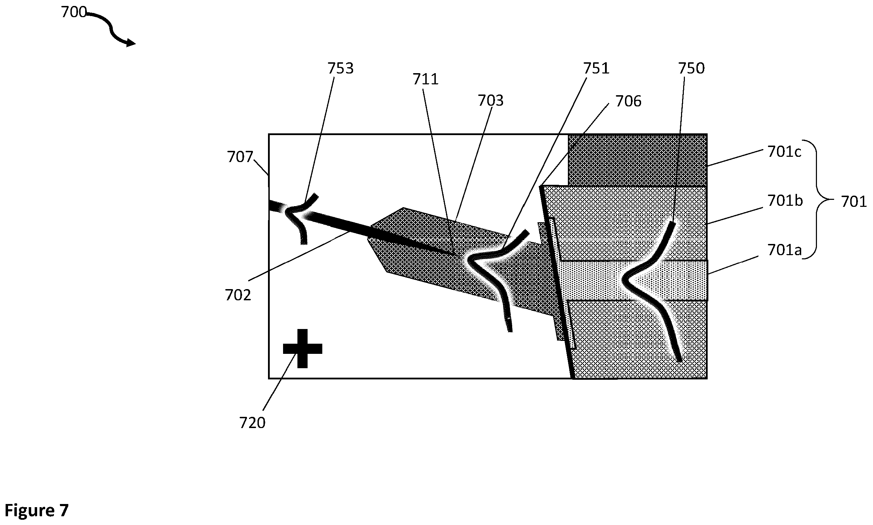

The term "coupled with," along with its derivatives, may be used herein. "Coupled" may mean one or more of the following. "Coupled" may mean that two or more elements are in direct physical, electrical, or optical contact. However, "coupled" may also mean that two or more elements indirectly contact each other, but yet still cooperate or interact with each other, and may mean that one or more other elements are coupled or connected between the elements that are said to be coupled with each other. The term "directly coupled" means that two or more elements are in direct contact in at least part of their surfaces. The term "butt-coupled" is used herein in its normal sense of meaning an "end-on" or axial coupling, where there is minimal or zero axial offset between the elements in question. The axial offset may be, for example, slightly greater than zero in cases where a thin intervening layer of some sort is formed between the elements, such as e.g. thin coating layer typically used to provide high-reflectivity or anti-reflectivity functionality. It should be noted that the axes of two waveguide structures or elements need not be colinear for them to be accurately described as being butt-coupled. In other words, the interface between the elements need not be perpendicular to either axis. FIG. 7 embodiments discussed below are exemplary of such possibilities. No adiabatic transformation occurs between butt-coupled structures.

Term "active device", "active structure" or otherwise "active" element, part, component may be used herein. A device or a part of a device called active is capable of light generation, amplification, modulation and/or detection using electrical contacts. This is in contrast to what we mean by a "passive device" whose principal function is to confine and guide light, and/or provide splitting, combining, filtering and/or other functionalities that are commonly associated with passive devices. Some passive devices can provide functions overlapping with active device functionality, such as e.g. phase tuning implemented using thermal effects or similar that can provide modulation. No absolute distinction should be assumed between "active" and "passive" based purely on material composition or device structure. A silicon device, for example, may be considered active under certain conditions of modulation, or detection of low wavelength radiation, but passive in most other situations.

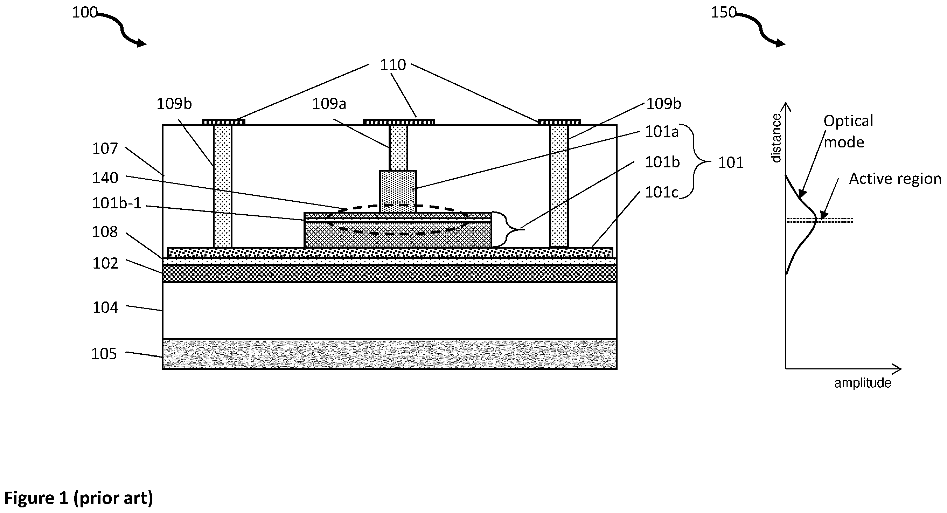

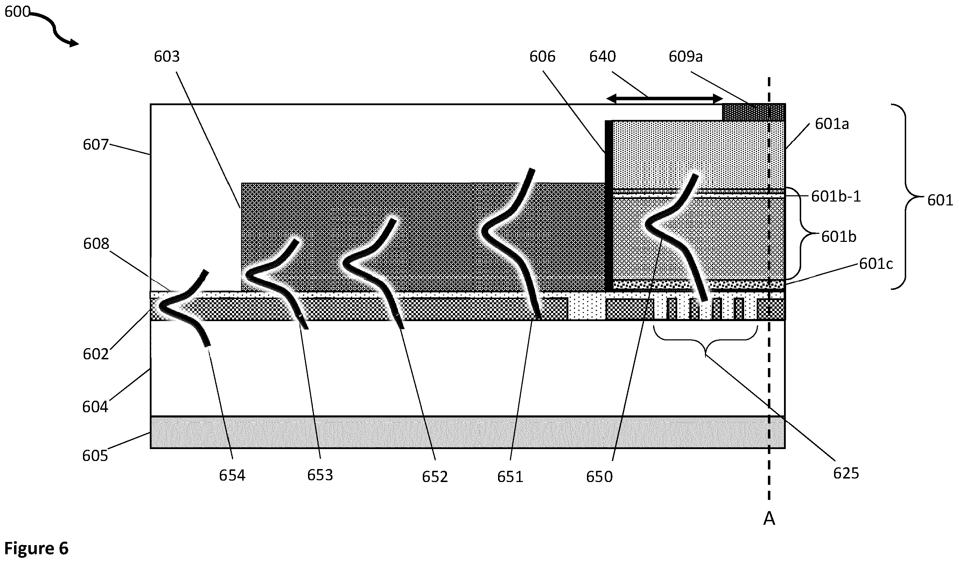

FIG. 1 (prior art) shows a cross-sectional view 100 corresponding to a region in which active layer 101 overlays the passive waveguide 102 as will be described with more details below. An exemplary location of such cross-sectional view is marked with A in FIG. 6, but it should be noted that the two embodiments (view 100 and FIG. 6) are not the same as will be explained in more details below and more specifically with the help of FIG. 6. In one embodiment, the material of layer 102 may include, but is not limited to, one or more of SiN, SiNOₓ, TiO₂, Ta₂O₅, (doped) SiO₂, LiNbO₃ and AIN. In some embodiments, other common dielectric materials may be used for layer 102. In other embodiments, a high-bandgap semiconductor material may be used for layer 102.

Layer 101 makes up what is commonly called an active device, and may be made up of materials including, but not limited to, InP and InP-based ternary and quaternary materials, GaAs and GaAs based ternary and quaternary materials, GaN, GaP, InAs and InSb and their variations and derivatives (including ternary and quaternary compounds) or any other suitable material for providing direct optical emission. Layer 101 comprises multiple sub-layers providing necessary functionality to realize active devices. In some embodiments layer 101 comprises three sublayers 101a, 101b and 101c as shown in view 100, where each of the sublayers can comprise additional sublayers with varying binary, ternary and quaternary compositions and various doping levels.

In one embodiment (as shown in 100), layer 101 is on top of layer 108 which provides a planarized surface for bonding as will be explained with the help of FIG. 6. In another embodiment (not shown), layer 101 may be on top of a combined top surface formed by layer 102 and layer 108 (not visible in this view) as planarization layer 108 would have been completely removed on top of layer 102 but still planarizes the etched regions of layer 102 with deposited material acting as a filler. In yet another embodiment (not shown), layer 101 is on top of layer 102 without a planarization layer filling in the etched regions of layer 102. In this embodiment there are pockets where layer 102 was etched.

Sublayer 101a in some embodiments comprises first contact layer (either p-contact or n-contact) and corresponding first cladding layer (p-cladding or n-cladding) with the optical mode being laterally confined by an etch defining the mesa or ridge (of width in a horizontal direction in view 100). The corresponding metal 109a (either p-metal or n-metal) is deposited on top of sublayer 101a with corresponding cladding layer of sublayer 101a serving to provide reduced internal loss by controlling the overlap between the optical mode 140 and metal 109a and between the optical mode 140 and contact layers of sublayer 101a. Sublayer 101a can comprise additional layers such as bandgap smoothing layers, etch stop layers, graded layers, separate-confinement heterostructure (SCH) layers, etc. to provide improved performance or facilitate more robust fabrication as is known in the art of semiconductor device design and fabrication.

Sublayer 101b comprises active region 101b-1 of the active device and a second cladding layer (opposite polarity (n or p) from the cladding present in sublayer 101a). In some embodiments the active region 101b-1 comprises quantum well and/or quantum dot layers with optional separate-confinement heterostructure (SCH) layer(s). In the remainder of this disclosure, including the claims, the term "quantum well region" is used for simplicity to include quantum dot layers as well as quantum well layers. The second cladding layer of sublayer 101b serves to provide reduced internal loss by controlling the overlap between the optical mode and sublayer 101c (described below) if sublayer 101c comprises materials that are lossy at the wavelength of the operation of the device. In other embodiments, the thickness of cladding layer of sublayer 101b serves to control the mode confinement in the active region in cases sublayer 101c comprises materials whose refractive indexes are comparable or higher than the refractive indices of the core (active region) for the optical mode 150.

Sublayer 101b can comprise additional layers such as bandgap smoothing layers, etch-stop layers, graded layers, at least part of the first cladding layer etc. to provide improved performance and facilitate more robust fabrication as is known in the art of semiconductor device design and fabrication. In this embodiment, the width of sublayer 101b, extending horizontally in cross-section 100, is greater than the width of sublayer 101a. In other embodiments, the width of sublayers 101a and 101b can be substantially equal if they are defined with a single etch, or multiple etches where target widths are nominally substantially equal. A general advantage of using two or more etches with different target widths for sublayer 101a and sublayer 101b (as sketched in view 100) is the ability to reduce the interaction of the etched sidewall with the optical mode 140 and/or move away etched active region sidewall from the interaction with both the optical mode and injected/depleted carriers (resulting in sidewall recombination) through contacts 110 to be described below.

Sublayer 101c comprises a second contact layer (opposite polarity (p or n) from the first contact layer in sublayer 101a) and optional superlattice layers to facilitate bonding and/or prevent dislocations. Sublayer 101c can comprise additional layers such as bandgap smoothing layers, etch-stop layers, graded layers, etc. to provide improved performance and facilitate more robust fabrication as is known in the art of semiconductor device design and fabrication. The width of sublayer 101c, as sketched in a horizontal direction in cross-section 100, is greater than the widths of sublayers 101a and 101b. Metal 109b is laterally offset from the optical mode 140 (whose lateral confinement is defined by at least one etch). Layer 102 can be un-patterned below the optical mode (as shown in cross-section 100), or patterned (not shown) to provide frequency-selective feedback to the optical mode 140 via evanescent field. This can be utilized to realize a distributed feedback (DFB) laser or similar devices.

Cladding 107 can comprise multiple materials, some of which might provide passivation functionality to the etched surfaces of layer 101 and its sublayers 101a, 101b, 101b-1 and 101c leading to improved laser performance. In some embodiments 107 may comprise one or more dielectric layers, providing at least partial cladding for modes supported by quantum well sublayers in the active region, and also electrical isolation between contact metals and vias connecting contact metals to pads. Contact metals 109a and 109b are electrically connected to pad metal 110 serving to provide current and/or voltage control of the active device.

The exemplary cross-section also includes a substrate 105 that can be any suitable substrate for semiconductor and dielectric processing, such as Si, InP, GaAs, quartz, sapphire, glass, GaN, silicon-on-insulator or other materials known in the art. In the shown embodiment, a layer of a second material 104 is deposited, grown, transferred, bonded or otherwise attached to the top surface of substrate 105 using techniques known in the field. The main purpose of layer 104 is to provide optical cladding for layer 102, if necessary to form an optical waveguide. Optical waveguides are commonly realized by placing higher refractive index core between two lower refractive index layers to confine the optical wave. In some embodiments, layer 104 is omitted and substrate 105 itself serves as a cladding.

View 150 shows a cross-section illustrating the confinement of the optical mode with respect to the position of the active region (layer 101b-1), with the peak of the optical mode being centered in the active region. This results in high active region confinement designs that can be beneficial in terms of the modal gain and laser threshold but may result in catastrophic optical damage (COD) if such lasers are operated at very high output power, due to high current/electron densities and high optical field intensities in the active region.

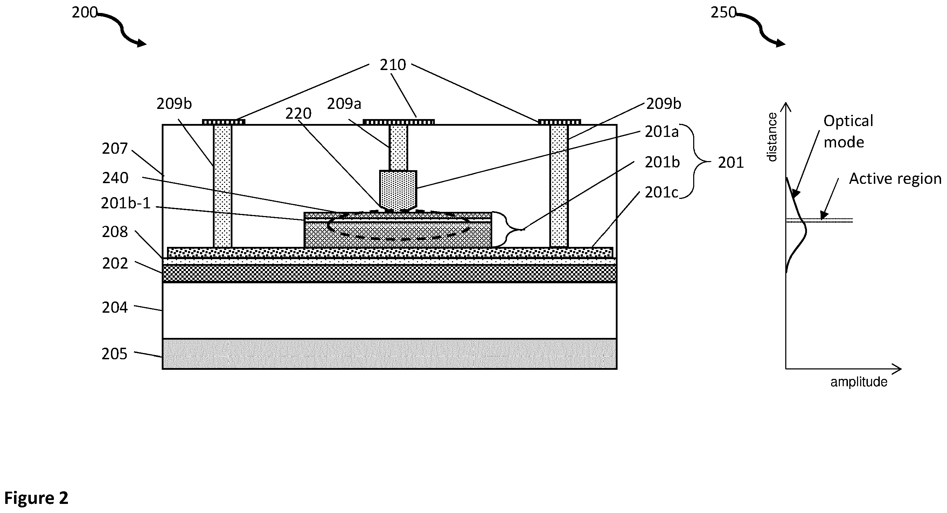

FIG. 2 shows one embodiment of the present invention in cross-sectional view 200 corresponding to an exemplary location such as that marked "A" in FIG. 6. Note that there could be differences between embodiments shown in FIG. 2 and FIG. 6. Functional layers 201 to 210 (unless explicitly defined differently) correspond to functional layers 101 to 110 as described in relation to FIG. 1. In contrast to the prior art device shown in FIG. 1, here in FIG. 2, sublayer 201a is etched in such way that there is an undercut 220 near sublayer 201b. Said undercut is at least the smaller of: (1) 10% of the total width of the layer 201a or (2) 150 nm in absolute value. The main purpose of the undercut 220 is to push the optical mode 240 towards the substrate and reduce the fraction of the mode confined in the active region, sublayer 201b-1.

View 250 shows a cross-section illustrating the confinement of the optical mode with respect to the active region (sublayer 201b-1) in more detail. In contrast to view 150, here the peak of the optical mode is shifted outside the active region reducing the optical field intensities in the active region which has high current/electron densities. This can increase the maximum output power achievable from the device before the onset of COD. The undercut enables control of the confinement, even in cases where layer 202 is designed for the peak of the optical mode to otherwise (without the undercut) be centered in the active region.

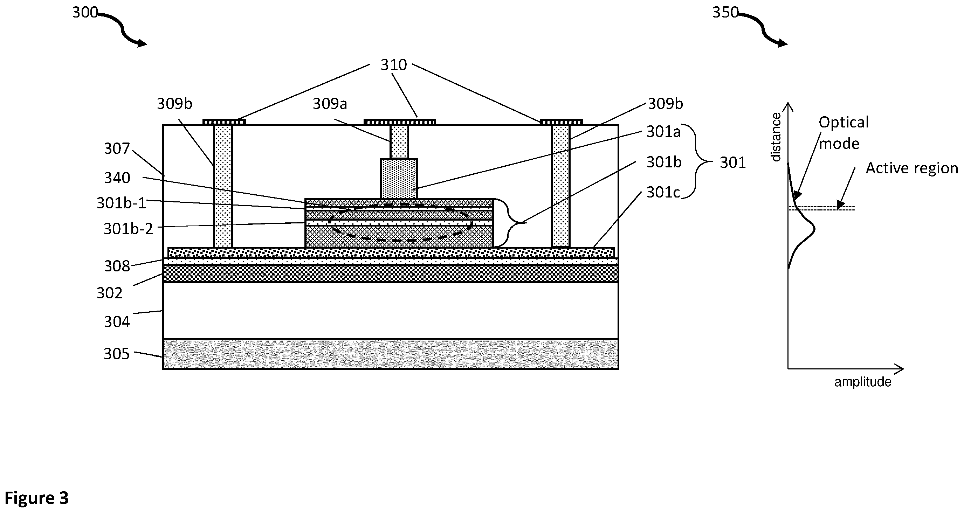

FIG. 3 shows one embodiment of the present invention in cross-sectional view 300 corresponding to an exemplary location such as that marked "A" in FIG. 6. Note that there could be differences between embodiments shown in FIG. 3 and FIG. 6. Functional layers 301 to 310 (unless explicitly defined differently) correspond to functional layers 101 to 110 as described in relation to FIG. 1. In contrast to the prior art device shown in FIG. 1, here in FIG. 3, sublayer 301b includes a waveguide sublayer 301b-2 positioned closer to the substrate than the active region 301b-1 and designed in such way that the intensity of the optical mode residing in the waveguide sublayer 301b-2 is higher than the intensity of the optical mode residing in the active region 301b-1. In this way the intensity of the optical mode is reduced in the active region 310b-1 as also shown in view 350.

Mode control can be enabled in several ways. As described above, it may be structurally enabled with the presence of an undercut in the sublayer above the active region, or an additional sublayer beneath the active region. In some embodiments, the thickness and/or refractive index of the waveguide sublayer 301b-2 is increased to pull the mode 340 further down toward the substrate. In other embodiments, asymmetry (in thickness and/or refractive index) between upper and lower SCH layers sandwiching the quantum well layers is utilized to pull the mode 340 down toward the substrate. In yet other embodiments both the thickness/refractive index of the waveguide sublayer 301b-2 and the optimization of the SCH layers are utilized.

View 350 shows a cross-section illustrating the confinement of the optical mode with respect to the active region (layer 301b-1) in more detail. In contrast to view 150, but as in the case of view 250, here the peak of the optical mode is shifted outside the active region reducing the optical field intensities in the active region which has high current/electron densities. This can increase the maximum output power achievable from the device before the onset of COD. The optimization results from the growth of an optimized layer 301 that comprises an additional waveguide sublayer 301b-2, relative to the prior art device illustrated in FIG. 1.

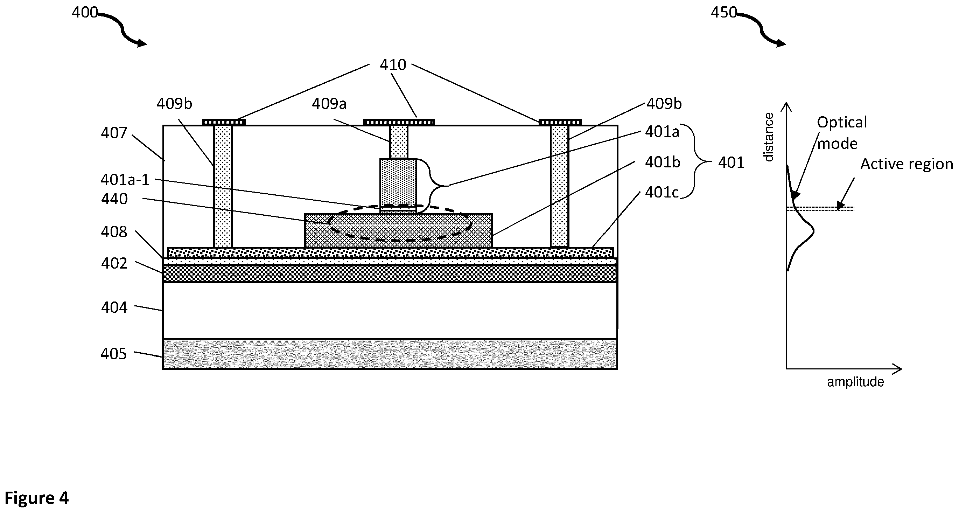

FIG. 4 shows one embodiment of the present invention in cross-sectional view 400 corresponding to an exemplary location such as that marked "A" in FIG. 6. Note that there could be differences between embodiments shown in FIG. 4 and FIG. 6. Functional layers 401 to 410 (unless explicitly defined differently) correspond to functional layers 101 to 110 as described in relation to FIG. 1. In contrast to the prior art device shown in FIG. 1, here in FIG. 4 the active region 401a-1 resides in sublayer 401a. This can be facilitated by performing a longer etch to define the sublayer 401a, effectively etching through the active region 401a-1 and/or by modifying the growth of layer 401 prior to bonding to the substrate as will be described with the help of FIG. 6. The main purpose of having active region 401a-1 be a part of sublayer 401 is to push the optical mode 440 towards the substrate and reduce the confinement in the active region 401a-1.

Sublayer 401a in some embodiments comprises a first contact layer (either p-contact or n-contact), a corresponding first cladding layer (p-cladding or n-cladding), active region 401a-1 of the active device and an optical part of a second cladding layer (opposite polarity (n or p) from the first cladding layer). Sublayer 401a can comprise additional layers such as bandgap smoothing layers, etch stop layers, graded layers, separate-confinement heterostructure (SCH) layers, etc. to provide improved performance or facilitate more robust fabrication as is known in the art of semiconductor device design and fabrication.

Sublayer 401b comprises at least part of the second cladding layer (opposite polarity (n or p) from the first cladding present in sublayer 401a). Sublayer 401b can comprise additional layers such as bandgap smoothing layers, etch-stop layers, graded layers, at least part of the first cladding layer etc. to provide improved performance and facilitate more robust fabrication as is known in the art of semiconductor device design and fabrication.

Sublayer 401c comprises a second contact layer (opposite polarity (p or n) from the first contact layer in sublayer 401a) and optional superlattice layers to facilitate bonding and/or prevent dislocations. Sublayer 401c can comprise additional layers such as bandgap smoothing layers, etch-stop layers, graded layers, etc. to provide improved performance and facilitate more robust fabrication as is known in the art of semiconductor device design and fabrication.

View 450 shows a cross-section illustrating the confinement of the optical mode with respect to the active region (layer 401a-1) in more detail. In contrast to view 150, but similarly to views 250 and 350, here the peak of the optical mode is shifted outside the active region, reducing the optical field intensities in the active region which has high current/electron densities. This can increase the maximum output power achievable before onset of COD. The optimization results from the utilizing longer etches to define sublayers 401a and 401b. In other embodiments, optimization is achieved by growing an optimized layer 401. In yet other embodiments, both approaches are used.

More than one of the approaches illustrated in FIGs. 2-4, can be combined in a single design to facilitate increase performance, reliability and/or manufacturability as would be known to someone skilled in the art.

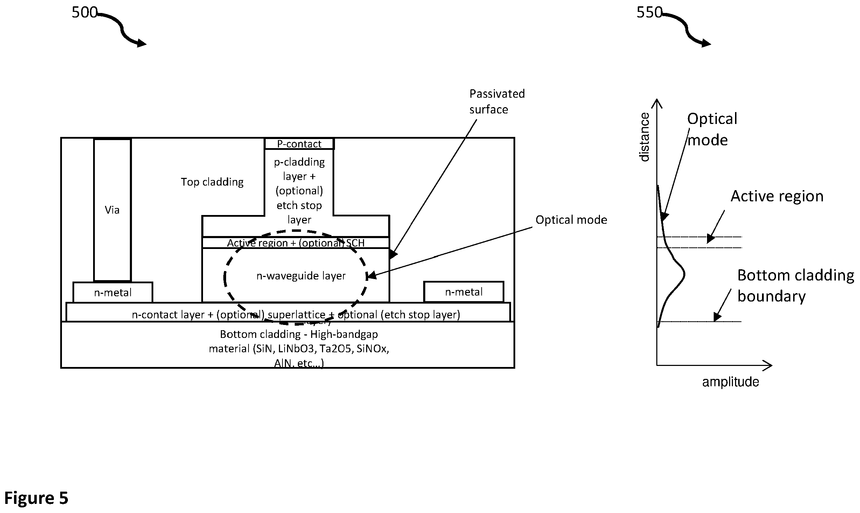

FIG. 5 shows an embodiment of the present invention in cross-sectional view 500 where bottom cladding functionality is provided at least in part by a high-bandgap material. Examples of such materials are SiN, LiNbO₃, Ta₂O₅, SiNOx, and AIN, but other suitable materials can be utilized. In some embodiments, the bandgap is larger than 1.2 eV. The peak of the optical mode resides in a waveguide layer such that the intensity of the optical mode is reduced in the active region. At least part of the optical mode (or its evanescent field) resides in the bottom cladding. In the embodiment shown in view 500, the n-contact layer is on the bottom, and p-contact layer is on the top. In other embodiments (not shown), the order of contact layers can be inverted. Additional optional layers such as etch stop layers, superlattice layers, bandgap smoothing layers, etc. can be utilized to provide improved performance and facilitate more robust fabrication as is known in the art of semiconductor device design and fabrication. Laser sidewalls and/or facets can be passivated, which is commonly done by deposition of thin layers of suitable materials such as e.g. SiN, Al₂O₃ or others. Other techniques can also be utilized.

FIG. 6 is a schematic cross-section view of an embodiment of an integrated photonic device 600 that incorporates an active structure such as those described above with reference to FIG's 2-5, and also utilizes butt-coupling and evanescent coupling for efficient coupling between that structure and structures comprising dissimilar materials as described with the help of FIGs. 6 and 7. In other embodiments, not shown, tapered coupling may be used instead of or in addition to butt-coupling, as is well known in the art. Functional layers 601 to 610 (unless explicitly defined differently) correspond to functional layers 101 to 110 as described in relation to FIG. 1. The characteristic location marked "A" indicates a location to which the end-on or lateral cross-section views shown in FIGs. 1-4 may correspond. Note that there could be differences between embodiments shown in FIGs. 1-4 and FIG. 6.

The exemplary cross-section includes a substrate 605. In the shown embodiment, a layer of a second material 604 is deposited, grown, transferred, bonded or otherwise attached to the top surface of substrate 605 using techniques known in the field. The main purpose of layer 604 is to provide optical cladding for material 602, if necessary to form an optical waveguide. In some embodiments, layer 604 is omitted and substrate 605 itself serves as a cladding.

Layer 602 is deposited, grown, transferred, bonded, or otherwise attached to the top of layer 604 if present, and/or to the top of substrate 605 if layer 604 is not present, using techniques known in the field. The refractive index of layer 602 is higher than the refractive index of layer 604 if present, or, if layer 604 is not present, the refractive index of layer 602 is higher than the refractive index of substrate 605. Layers 604 and/or 602 can be patterned, etched, or redeposited to tailor their functionality (define waveguides, splitters, couplers, gratings and other passive components) as is common in the art. In some embodiments part of layer 602 can act as a distributed grating to the optical mode 650 dominantly residing inside layer 601. An example of such structure is shown with patterned section 625. Such a structure can serve to e.g., realize a distributed feedback laser.

Layer 608, whose refractive index is lower than the refractive index of layer 602, overlies layer 602 and underlies layers 601 and 603, and serves to planarize the patterned surface of layer 602. In some embodiments, the planarity of the top surface of layer 608 is provided by chemical mechanical polishing (CMP) or other etching, chemical and/or mechanical polishing methods. In other embodiments, the planarity is provided because of the intrinsic nature of the method by which layer 608 is deposited, for example if the material of layer 608 is a spin-on glass, polymer, photoresist or other suitable material. The planarization may be controlled to leave a layer of desired, typically very low, thickness on top of the layer 602 (as shown in FIG. 6), or to remove all material above the level of the top surface of the layer 602 (not shown). In the cases where layer 608 is left on top of layer 602, the target thicknesses are in the range of few nm to several hundreds of nm, with actual thickness, due to planarization process non-uniformities, being between zero and several hundreds of nanometers larger than the target thickness. In some embodiments, spin-on material is deposited and then etched back resulting with improved planarization across wafer uniformity compared to typical CMP processes. In yet another embodiment (not shown), there is no planarization layer 608 filling in the etched regions of layer 602. In this embodiment there would be depressions or pockets where layer 602 was etched.

Layer 601 is attached onto a top surface of layer 608, in the embodiment shown. In another embodiment, where no layer 608 is present at all, 601 may be attached onto either an unbroken top surface of layer 602, or an etched top surface, with air spaces formed by etching the material of layer 602. In yet other embodiments, layer 601 is attached on top surface formed by etched surface of layer 602 with etched spaces filled in by 608 forming a combined, planarized surface formed by layers 602 and 608. The attachment can utilize direct molecular bonding or can use additional materials to facilitate bonding such as e.g., metal layers or polymer films as is known in the art. Layer 601 makes up what is commonly called an active device and may be multilayered. In the embodiment shown in FIG. 6, layer 601 comprises three sublayers 601a, 601b and 601c, and the active region is in the sublayer 601b-1. In other embodiments, as shown in FIG. 4, part or all of the active region can be in a different sublayer.

The widths of sub-layers 601a-601c are not visible in this view but corresponding widths are shown in the views of FIGs. 1-4. The widths are defined by at least one etch after the bonding of layer 601. This facilitates precise alignment, as the etch can utilize common alignment marks 720 as indicated in FIG. 7.

In some embodiments, layer 601 can be efficiently electrically pumped to generate optical emission and gain. The present invention enables efficient optical coupling between waveguides formed in layer 601 and layer 602, when layer 601 is optimized for high-power operation. The material(s) of layer 602 can provide additional functionality such as wide-band transparency, high intensity handling, phase shifting by temperature, strain or other tuning mechanisms, combining, splitting, filtering, non-linear generation and/or others as is known in the art.

Efficient coupling is facilitated by layer 603, and, in cases where layer 606 is present, by layer 606. Optional layer 606 primarily serves as either an anti-reflective or a highly-reflective coating at the interface between layer 601 and layer 603. Layer 603 serves as an intermediate waveguide that in some embodiments accepts the profile (depicted by line 650) of an optical mode supported by the waveguide for which layer 601 provides the core, captures it efficiently as mode profile 651, and gradually transfers it to mode profiles 652, 653 and finally 654. Mode profile 654 is efficiency coupled and supported in the waveguide for which layer 602 provides the core.

The refractive index and dimensions of layer 603 can be engineered to facilitate efficient butt-coupling of mode profile 650 and to efficiently transform the mode to one with mode profile 654 by taking advantage of tapered structures made in layer 602 and/or 603.

Differences between the optical modes supported by waveguides in layers 601 and 602 respectively may or may not be obvious by observation of the mode profiles, but mode overlaps less than 100% and vertical offset (in FIG. 6) between modes 650 and 654 could (in the absence of intermediate layer 603) result in significant optical loss. In some cases, it may be considered that losses of up to 2dB are acceptable, but losses greater than that are not. In other cases, a 5dB loss level may be the criterion chosen. The function of layer 603 is to keep optical coupling loss due to imperfect mode overlap and vertical offset (between modes 150 and 154) below whatever is determined to be an acceptable level in a given application.

The upper cladding layer 607 for waveguides realized in 603 and/or 602 can be ambient air (meaning no cladding material is actually deposited) or can be any other deliberately deposited suitable material as shown in FIG. 6, including, but not limited to, a polymer, SiO2, SiN, SiNOx etc. In some embodiments same material is used for layer 607 and layer 608. In some embodiments (not shown), layer 607 cladding functionality can be provided with multiple depositions, e.g. one material provides the cladding for mode 654 guided by core formed in layer 602, and another material provides the cladding for modes 653-651 guided by core formed in layer 603. In all cases, the refractive index of cladding material is lower than the refractive index of the material which provides the core for the mode guiding. In yet another embodiment (not shown here), layer 603 can provide cladding functionality to layer 602 and mode 654.

Layer 609a is a contact metal deposited on top of layer 601 as described in more detail with the help of FIGs. 2-4. In some embodiments, it is beneficial to pull back metal 609a from the lateral² facet of the active structure (butt-coupled interface between layers 601 and 603), reducing the carrier concentration near the facet. This can increase the maximum output power before onset of COD. Pullback can be defined as the distance between the facet and start of the metal as shown with arrow 640. In some embodiments, distance 640 is at least 1 µm or more. In other embodiments it is greater than 10 µm. In yet other embodiments it is greater than 100 µm.
² Lateral is understood to mean perpendicular to direction of propagation of the optical mode inside the active structure.

One or more lithography alignment marks (not shown in this cross-sectional view, but see, for example, 720 in FIG. 7, described below) are present to facilitate precise alignment between the layers formed during various processing steps.

It may be noted that several of the features (e.g., butt coupling, intermediate waveguides etc.,) included in the embodiments shown in FIG. 6 (and FIG 7 to be discussed below) are disclosed in prior publications, such as U.S. Patent No. 1,071,889,8B1.

FIG. 7 depicts a top-down view of an integrated photonic device 700 according to one embodiment of the present invention, similar to device 600 described above. Functional layers 701 to 707 (unless explicitly defined differently) correspond to functional layers 101 to 107 as described in relation to FIG. 1.

The optical mode 750 supported by active layer 701 (defined by at least one lateral etch defining width of sublayer 701a) is guided through optional coating layer 706 to layer 703 that supports optical mode 751 and serves to convert the mode for efficient coupling to layer 702 which supports mode 753. Layer 706 can provide high-reflection functionality, or can facilitate reduced reflection when designed to function as anti-reflection coating.

A first mode transition, from mode 750 to 751, utilizes butt-coupling. In some embodiments, one or more of the interfaces between layers 701 (comprising sublayers 701a, 701b and 701c), 706 and/or 703 are angled to reduce corresponding back reflection(s) as is known in the art of butt-coupled interfaces. In other embodiments, they are perpendicular to the direction of the propagation of the mode 750 to intentionally provide reflection, e.g. in the case of Fabry-Perot lasers or similar structures.

Once mode 750 is efficiently captured into mode 751 supported by the core defined in layer 703 utilizing butt-coupling, at least one of the two layers, 703 and 702, is tapered to facilitate efficient mode transfer from mode 751 to 753. In all cases, the requirements on the dimensions of tip 711 of layer 702 are significantly relaxed, so complete coupling structure can be defined using standard lithography tools.

One or more lithography alignment marks 720 (only one is shown for simplicity) are used for precise alignment between various processing steps.

It is to be understood that these illustrative embodiments teach just several examples of heterogeneously integrated lasers and active components optimized for high-power operation utilizing the present invention, and many similar arrangements can be further envisioned. Furthermore, such lasers and active components can be combined with multiple other components to provide additional functionality or better performance such as various filtering elements, amplifiers, monitor photodiodes, modulators and/or other photonic components.

Embodiments of the present invention offer many benefits. The integration platform enables scalable manufacturing of PICs made from multiple materials providing higher-performance and/or ability to operate in broadband wavelength range. Furthermore, the platform is capable of handling high optical power compared to typical Si waveguide-based or InP waveguide-based PICs.

This present invention utilizes a process flow consisting of typically wafer-bonding of a piece of compound semiconductor material on a carrier wafer with dielectric waveguides (as is described with the help of FIG. 6) and subsequent semiconductor fabrication processes as is known in the art. It enables an accurate definition of optical alignment between active and passive waveguides via typically photo lithography step, removing the need for precise physical alignment. Said photo lithography-based alignment allows for scalable manufacturing using wafer scale techniques.

It is to be understood that optical coupling between modes in active and passive layers is reciprocal, so that, taking FIG. 6 as exemplary, the structure can be configured to facilitate light transmission from region 601 to region 602, but also to facilitate transmission in the reverse direction, from region 602 to region 601. In is to be understood that multiple such transitions with no limitation in their number or orientation can be realized on a suitably configured PIC.

Other approaches have relied on die attachment of pre-fabricated optical active devices to passive waveguides. This requires very stringent alignment accuracy which is typically beyond what a typical die-bonder can provide. This aspect limits the throughput of this process as well as the performance of optical coupling.

In some embodiments the active device can utilize the substrate for more efficient thermal sinking, due to direct contact to the substrate with no dielectric in-between.

In some embodiments, the active device creates a hybrid waveguide structure with dielectric layers which can be used, for example, to create a wavelength selective component formed inside the laser cavity for e.g. distributed feedback (DFB) lasers or similar components.

Embodiments of the optical devices described herein may be incorporated into various other devices and systems including, but not limited to, various computing and/or consumer electronic devices/appliances, communication systems, medical devices, sensors and sensing systems.

It is to be understood that the disclosure teaches just few examples of the illustrative embodiment and that many variations of the invention can easily be devised by those skilled in the art after reading this disclosure and that the scope of the present invention is to be determined by the following claims.

## Claims

1. A device (600, 700) comprising:
an active structure in an element (101, 201, 301, 401, 601, 701) attached to a substrate (105, 205, 305, 405, 605), the active structure comprising an active region (101b-1, 201b-1, 301b-1, 401a-1) comprising a quantum well region(101b-1, 201b-1, 301b-1, 401a-1);
wherein all material layers that underlie the active structure and overlie the substrate (105, 605) are dielectric layers; and
wherein an optical mode (140, 150, 240, 340, 440, 650, 750) supported by the device (600, 700) in a region (101, 201, 301, 401, 601, 701) including the active structure is **characterized by** an amplitude having a peak value offset, in a direction towards the substrate (105, 605), from the quantum well region (101b-1, 201b-1, 301b-1, 401a-1);
**characterized in that**
a dielectric layer between the active structure and the substrate (105, 205, 305, 405, 605) is one of silicon nitride, silicon oxynitride, tantalum pentoxide, titanium dioxide, lithium niobate and aluminum nitride, and/or
there is an undercut (220) in a cladding layer (201a) of the active structure, overlying the active region (101b-1, 201b-1, 301b-1, 401a-1) of the active structure, and/or
the peak value of amplitude of the optical mode (140, 150, 240, 340, 440, 650, 750) supported by the device (600, 700) in a region (101, 201, 301, 401, 601, 701) including the active structure is present in a waveguide sublayer (301b-2) of the active structure, and/or
an upper cladding sublayer of the active structure, of width smaller than a width characterizing a lower cladding sublayer of the active structure, comprises the quantum well region (101b-1, 201b-1, 301b-1, 401a-1).

2. The device (600, 700) of claim 1,
wherein the cladding layer (101a, 201a, 301a, 401a) of the active structure is **characterized by** a lateral width; and
wherein the undercut (220) has a lateral extent of at least the smaller of 10% of the lateral width and 150nm.

3. The device (600, 700) according to any of the preceding claims, wherein the optical mode (140, 150, 240, 340, 440, 650, 750) is **characterized by** an optical power of at least 30mW.

4. The device (600, 700) according to any of the preceding claims, further comprising a passive structure (602, 702), attached to the substrate (105, 605), wherein the passive structure is configured to couple optically to the active structure.

5. The device (600, 700) of claim 4, further comprising a contact metal (609a) overlying the active structure;
wherein a portion of the optical coupling occurs at a lateral facet of the active structure; and
wherein the contact metal (609a) is offset axially from the lateral facet by a predetermined distance.

6. The device (600, 700) of claim 5,
wherein the predetermined distance is at least 1um.

7. The device (600, 700) according to any of the preceding claims 4 to 6,
wherein the optical coupling occurs at a lateral facet of the active structure; and
wherein the lateral facet is angled at a value optimized to minimize reflections.

8. The device (600, 700) according to any of the preceding claims 4 to 7, wherein a passive region (602) between the active structure and the substrate (105, 605) comprises a frequency selective structure (625) configured to provide grating functionality.

## Patentansprüche

1. Vorrichtung (600, 700), umfassend:
eine aktive Struktur in einem Element (101, 201, 301, 401, 601, 701), das an einem Substrat (105, 205, 305, 405, 605) angebracht ist, wobei die aktive Struktur einen aktiven Bereich (101b-1, 201b-1, 301b-1, 401a-1) umfasst, der einen Quantentopfbereich (101b-1, 201b-1, 301b-1, 401a-1) umfasst;
wobei alle Materialschichten, die unter der aktiven Struktur liegen und über dem Substrat (105, 605) liegen, dielektrische Schichten sind; und
wobei ein optischer Modus (140, 150, 240, 340, 440, 650, 750), der durch die Vorrichtung (600, 700) in einem Bereich (101, 201, 301, 401, 601, 701), der die aktive Struktur aufweist, unterstützt ist, durch eine Amplitude gekennzeichnet ist, die einen Spitzenwertversatz in Richtung des Substrats (105, 605) von dem Quantentopfbereich (101b-1, 201b-1, 301b-1, 401a-1) aufweist;
**dadurch gekennzeichnet, dass**
eine dielektrische Schicht zwischen der aktiven Struktur und dem Substrat (105, 205, 305, 405, 605) aus einem von Siliziumnitrid, Siliziumoxynitrid, Tantalpentoxid, Titandioxid, Lithiumniobat und Aluminiumnitrid besteht, und/oder
in einer Mantelschicht (201a) der aktiven Struktur, die über dem aktiven Bereich (101b-1, 201b-1, 301b-1, 401a-1) der aktiven Struktur liegt, eine Unterschnittkante (220) vorhanden ist, und/oder
der Spitzenwert der Amplitude des optischen Modus (140, 150, 240, 340, 440, 650, 750), der durch die Vorrichtung (600, 700) in einem Bereich (101, 201, 301, 401, 601, 701) einschließlich der aktiven Struktur unterstützt ist, in einer Wellenleiter-Unterschicht (301b-2) der aktiven Struktur vorliegt, und/oder
eine obere Mantelunterschicht der aktiven Struktur, deren Breite kleiner ist als eine Breite, die eine untere Mantelunterschicht der aktiven Struktur kennzeichnet, den Quantentopfbereich (101b-1, 201b-1, 301b-1, 401a-1) umfasst.

2. Vorrichtung (600, 700) nach Anspruch 1,
wobei die Mantelschicht (101a, 201a, 301a, 401a) der aktiven Struktur durch eine seitliche Breite gekennzeichnet ist; und
wobei die Unterschnittkante (220) eine seitliche Erstreckung von mindestens
10 % der seitlichen Breite oder 150 nm aufweist, je nachdem, was kleiner ist.

3. Vorrichtung (600, 700) nach einem der vorhergehenden Ansprüche, wobei der optische Modus (140, 150, 240, 340, 440, 650, 750) durch eine optische Leistung von mindestens 30 mW gekennzeichnet ist.

4. Vorrichtung (600, 700) nach einem der vorhergehenden Ansprüche, ferner umfassend eine passive Struktur (602, 702), die an dem Substrat (105, 605) angebracht ist, wobei die passive Struktur eingerichtet ist, um optisch mit der aktiven Struktur gekoppelt zu sein.

5. Vorrichtung (600, 700) nach Anspruch 4, ferner umfassend ein Kontaktmetall (609a), das über der aktiven Struktur liegt;
wobei ein Teil der optischen Kopplung an einer seitlichen Facette der aktiven Struktur erfolgt; und
wobei das Kontaktmetall (609a) um einen vorbestimmten Abstand axial von der seitlichen Facette versetzt ist.

6. Vorrichtung (600, 700) nach Anspruch 5,
wobei der vorbestimmte Abstand mindestens 1 µm beträgt.

7. Vorrichtung (600, 700) nach einem der vorhergehenden Ansprüche 4 bis 6,
wobei die optische Kopplung an einer seitlichen Facette der aktiven Struktur erfolgt; und
wobei die seitliche Facette in einem Winkel angeordnet ist, der optimiert ist, um Reflexionen zu minimieren.

8. Vorrichtung (600, 700) nach einem der vorhergehenden Ansprüche 4 bis 7, wobei ein passiver Bereich (602) zwischen der aktiven Struktur und dem Substrat (105, 605) eine frequenzselektive Struktur (625) umfasst, die eingerichtet ist, um eine Gitterfunktionalität bereitzustellen.

## Revendications

1. Dispositif (600, 700), comprenant :
une structure active dans un élément (101, 201, 301, 401, 601, 701) fixé à un substrat (105, 205, 305, 405, 605), la structure active comprenant une zone active (101b-1, 201b-1, 301b-1, 401a-1) comprenant une zone de puits quantique (101b-1, 201b-1, 301b-1, 401a-1) ;
dans lequel toutes les couches de matériau situées sous la structure active et recouvrant le substrat (105, 605) sont des couches diélectriques ; et
dans lequel un mode optique (140, 150, 240, 340, 440, 650, 750) pris en charge par le dispositif (600, 700) dans une zone (101, 201, 301, 401, 601, 701) comportant la structure active est **caractérisé par** une amplitude présentant un décalage de valeur de crête, en direction du substrat (105, 605), à partir de la zone de puits quantique (101b-1, 201b-1, 301b-1, 401a-1) ;
**caractérisé en ce que**
une couche diélectrique située entre la structure active et le substrat (105, 205, 305, 405, 605) est un parmi le nitrure de silicium, l'oxynitrure de silicium, l'anhydride tantalique, le dioxyde de titane, le niobate de lithium, et le nitrure d'aluminium, et/ou
une contre-dépouille (220) se trouve dans une couche de gainage (201a) de la structure active, recouvrant la zone active (101b-1, 201b-1, 301b-1, 401a-1) de la structure active, et/ou
la valeur de crête de l'amplitude du mode optique (140, 150, 240, 340, 440, 650, 750) pris en charge par le dispositif (600, 700) dans une zone (101, 201, 301, 401, 601, 701) comportant la structure active est présente dans une sous-couche de guide d'ondes (301b-2) de la structure active, et/ou
une sous-couche de gainage supérieure de la structure active, d'une largeur inférieure à la largeur caractérisant une sous-couche de gainage inférieure de la structure active, comprend la zone de puits quantique (101b-1, 201b-1, 301b-1, 401a-1).

2. Dispositif (600, 700) selon la revendication 1,
dans lequel la couche de gainage (101a, 201a, 301a, 401a) de la structure active est **caractérisée par** une largeur latérale ; et
dans lequel la contre-dépouille (220) présente une étendue latérale au moins égale à la valeur la plus faible entre 10 % de la largeur latérale et 150 nm.

3. Dispositif (600, 700) selon l'une quelconque des revendications précédentes, dans lequel le mode optique (140, 150, 240, 340, 440, 650, 750) est **caractérisé par** une puissance optique d'au moins 30 mW.

4. Dispositif (600, 700) selon l'une quelconque des revendications précédentes, comprenant en outre une structure passive (602, 702), fixée au substrat (105, 605), la structure passive étant conçue pour venir en couplage optique avec la structure active.

5. Dispositif (600, 700) selon la revendication 4, comprenant en outre un métal de contact (609a) recouvrant la structure active ;
dans lequel une partie du couplage optique s'effectue sur une facette latérale de la structure active ; et
dans lequel le métal de contact (609a) est décalé axialement par rapport à la facette latérale selon une distance prédéfinie.

6. Dispositif (600, 700) selon la revendication 5, dans lequel la distance prédéfinie est d'au moins 1 µm.

7. Dispositif (600, 700) selon l'une quelconque des revendications précédentes 4 à 6,
dans lequel le couplage optique s'effectue sur une facette latérale de la structure active ; et
dans lequel la facette latérale est inclinée selon une valeur optimisée pour minimiser les reflets.

8. Dispositif (600, 700) selon l'une quelconque des revendications précédentes 4 à 7, dans lequel une zone passive (602) entre la structure active et le substrat (105, 605) comprend une structure sélective en fréquence (625) conçue pour fournir une fonctionnalité de mire.
